# EUROPEAN PATENT APPLICATION

(11) **EP 2 565 933 A1**
(43) Date of publication of application: **06.03.2013**
(21) Application number: 11774899.6
(22) Date of filing: 21.04.2011
(51) Int. Cl.: H01L 31/04

(54) **BACK CONTACT SOLAR CELL AND METHOD FOR MANUFACTURING BACK CONTACT SOLAR CELL**

(30) Priority: 27.04.2010 JP 2010101631
(71) Applicant: Sharp Kabushiki Kaisha, Osaka-shi, Osaka 545-8522 (JP)
(72) Inventor: ISAKA, Takayuki, Osaka-shi, Osaka 545-8522 (JP)
(74) Representative: Müller - Hoffmann & Partner
(86) International application number: PCT/JP2011/059795
(87) International publication number: WO 2011/136116

(57) **Abstract**

There is provided a back electrode type solar cell (1, 14) including: a silicon substrate (4) of a first conductivity type; an electrode for the first conductivity type (2) and an electrode for a second conductivity type (3) provided at a back surface opposite to a light-receiving surface of the silicon substrate (4); and a first conductivity type impurity diffusion layer (9) and a second conductivity type impurity diffusion layer (10) provided at the back surface of the silicon substrate (4), the first conductivity type impurity diffusion layer (9) and the second conductivity type impurity diffusion layer (10) being adjacently provided, the first conductivity type impurity diffusion layer (9) being provided at a peripheral edge of the back surface of the silicon substrate (4), and a method for producing the back electrode type solar cell.

## Description

### TECHNICAL FIELD

The present invention relates to a back electrode type solar cell and a method for producing the back electrode type solar cell.

### BACKGROUND ART

In recent years, the solar cells that convert solar energy directly into electrical energy are increasingly, rapidly expected as an energy source for the next generation in view of global environmental issues in particular. While there is a variety of solar cells such as those using compound semiconductor, organic material and/or the like, those using silicon crystal are currently mainstream.

A type of solar cell currently most produced and sold has a structure with a surface on which solar light is incident (i.e., a light-receiving surface) and a surface opposite to the light-receiving surface (i.e., a back surface) provided with electrodes, respectively.

When an electrode is formed on a light-receiving surface of a solar cell, the electrode absorbs solar light, and the solar cell thus receives solar light at the light-receiving surface in an amount reduced by that corresponding to the electrode's footprint. Accordingly, a solar cell of a structure having an electrode only at the back surface, i.e., a back electrode type solar cell, is being developed.

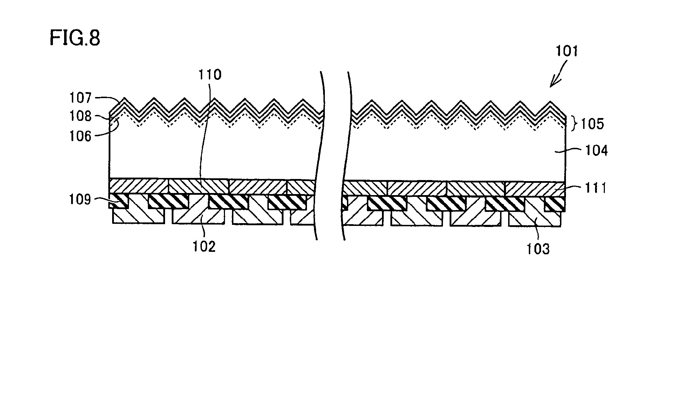

Fig. 8 shows a schematic cross sectional view of a conventional back electrode type solar cell disclosed in Patent Literature 1 (Japanese National Patent Publication No. 2008-532311).

On a light-receiving surface of a conventional back electrode type solar cell 101 shown in Fig. 8, an n type front surface diffusion region 106 is formed to form an FSF (Front Surface Field) structure. Furthermore, back electrode type solar cell 101 has the light-receiving surface with a concave-convex structure 105 and thereon a dielectric passivation layer 108 including silicon dioxide and an antireflection coating 107 including silicon nitride are provided in this order from a side of an n type silicon wafer 104.

Furthermore, n type silicon wafer 104 has a back surface having an n type impurity-doped n+ region 110 and a p type impurity-doped p+ region 111 provided alternately and on the back surface of n type silicon wafer 104 an oxide layer 109 is provided. A metal contact for n type 102 is provided on n+ region 110 in the back surface of n type silicon wafer 104, and a metal contact for p type 103 is provided on p+ region 111 located in the back surface of n type silicon wafer 104.

### CITATION LIST

### PATENT LITERATURE

Patent Literature 1: Japanese National Patent Publication No. 2008-532311

### SUMMARY OF INVENTION

### TECHNICAL PROBLEM

When a back electrode type solar cell module having a plurality of back electrode type solar cells connected in series or parallel is in operation with a portion shaded as it does not receive solar light, reverse bias voltage is applied to the back electrode type solar cell or cells that is/are located at the shaded portion in a relation with the other back electrode type solar cells.

If the reverse bias voltage is applied to back electrode type solar cell 101 that has a back surface with a peripheral edge having a region of a conductivity type different from that of n type silicon wafer 104, i.e., a p+ region, as described in Patent Literature 1, back electrode type solar cell 101 easily causes current leakage through the peripheral edge.

In view of the above circumstance, an object of the present invention is to provide a back electrode type solar cell which can reduce/prevent current leakage caused when reverse bias voltage is applied, and a method for producing the back electrode type solar cell.

### SOLUTION TO PROBLEM

The present invention is a back electrode type solar cell including: a silicon substrate of a first conductivity type; an electrode for the first conductivity type and an electrode for a second conductivity type provided at a back surface opposite to a light-receiving surface of the silicon substrate; and a first conductivity type impurity diffusion layer and a second conductivity type impurity diffusion layer provided at the back surface of the silicon substrate, the first conductivity type impurity diffusion layer and the second conductivity type impurity diffusion layer being adjacently provided, the first conductivity type impurity diffusion layer being provided at a peripheral edge of the back surface of the silicon substrate.

Herein in the back electrode type solar cell of the present invention preferably a total area of the first conductivity type impurity diffusion layer is smaller than that of the second conductivity type impurity diffusion layer in the back surface of the silicon substrate.

Furthermore in the back electrode type solar cell of the present invention preferably the first conductivity type is n type.

Furthermore in the back electrode type solar cell of the present invention preferably a light-receiving surface diffusion layer that contains a first conductivity type impurity at a higher concentration than the silicon substrate is provided in a light-receiving surface of the silicon substrate.

Furthermore in the back electrode type solar cell of the present invention preferably a light-receiving surface passivation film is provided on the light-receiving surface diffusion layer, an anti-reflection film is provided on the light-receiving surface passivation film, and the anti-reflection film includes titanium oxide containing an impurity of the first conductivity type.

Furthermore in the back electrode type solar cell of the present invention preferably the light-receiving surface passivation film has a thickness of 15 nm to 200 nm.

Furthermore in the back electrode type solar cell of the present invention preferably the anti-reflection film contains phosphoric oxide as the impurity in an amount of 15% by mass to 35% by mass of the anti-reflection film.

Furthermore in the back electrode type solar cell of the present invention preferably the second conductivity type impurity diffusion layer is surrounded by the first conductivity type impurity diffusion layer.

Furthermore in the back electrode type solar cell of the present invention preferably the second conductivity type impurity diffusion layer is provided in a form of an island.

Herein in the back electrode type solar cell of the present invention preferably the first conductivity type impurity diffusion layer forms a single diffusion layer region.

Furthermore the present invention is a method for producing a back electrode type solar cell, including the steps of: providing a first conductivity type impurity diffusion layer at a portion of a back surface of a silicon substrate of a first conductivity type; providing silicon oxide film on the back surface of the silicon substrate by thermal oxidation; providing a second conductivity type impurity diffusion layer at the back surface of the silicon substrate by utilizing a difference in thickness between the silicon oxide film on the back surface of the silicon substrate at a region where the first conductivity type impurity diffusion layer is formed and the silicon oxide film on the back surface of the silicon substrate at a region where the first conductivity type impurity diffusion layer is not formed; providing an electrode for the first conductivity type on the first conductivity type impurity diffusion layer; and providing an electrode for a second conductivity type on the second conductivity type impurity diffusion layer.

Herein the method for producing a back electrode type solar cell of the present invention preferably further includes the step of etching a portion of the silicon oxide film before the step of providing the second conductivity type impurity diffusion layer.

Furthermore in the method for producing a back electrode type solar cell of the present invention preferably in the step of etching a portion of the silicon oxide film the silicon oxide film is left only on the first conductivity type impurity diffusion layer.

Furthermore in the method for producing a back electrode type solar cell of the present invention preferably the silicon oxide film left only on the first conductivity type impurity diffusion layer has a thickness of not less than 60 nm.

Furthermore in the method for producing a back electrode type solar cell of the present invention preferably in the step of providing the first conductivity type impurity diffusion layer a first conductivity type impurity concentration of the first conductivity type impurity diffusion layer is not less than 5 × 10¹⁹ atoms/cm³.

### ADVANTAGEOUS EFFECTS OF INVENTION

The present invention can thus provide a back electrode type solar cell which can reduce/prevent current leakage caused when reverse bias voltage is applied, and a method for producing the back electrode type solar cell.

### BRIEF DESCRIPTION OF DRAWINGS

Fig. 1 is a schematic plan view of a back surface of a back electrode type solar cell of a first embodiment.
Fig. 2(a) is a schematic cross sectional view along a line II-II of Fig. 1, Fig. 2(b) is a schematic enlarged cross sectional view of a portion of a light-receiving surface of an n type silicon substrate shown in Fig. 2(a), and Fig. 2(c) is a schematic enlarged cross sectional view for illustrating a relationship in thickness between an n++ layer and a p+ layer shown in Fig. 2(a).
Fig. 3 is a schematic plan view of a back surface of an n type silicon substrate when an electrode for n type, an electrode for p type, and a back surface passivation film are removed from the back electrode type solar cell of the first embodiment.
Figs. 4(a) to 4(h) are schematic cross sectional views for illustrating an example of a method for producing the back electrode type solar cell of the first embodiment.
Fig. 5(a) is a schematic cross sectional view of a back electrode type solar cell of a second embodiment, Fig. 5(b) is a schematic enlarged cross sectional view of a portion of a light-receiving surface of an n type silicon substrate shown in Fig. 5(a), and Fig. 5(c) is a schematic enlarged cross sectional view for illustrating a relationship in thickness between an n++ layer and a p+ layer shown in Fig. 5(a).
Figs. 6(a) to 6(i) are schematic cross sectional views for illustrating an example of a method for producing the back electrode type solar cell of the second embodiment.
Figs. 7(a) to 7(i) are schematic cross sectional views for illustrating an example of a method for producing a back electrode type solar cell of a third embodiment.
Fig. 8 is a schematic cross sectional view of a conventional back electrode type solar cell disclosed in Patent Literature 1.

### DESCRIPTION OF EMBODIMENTS

Hereinafter, the present invention will be described in embodiments. In the figures of the embodiments, identical or corresponding components are identically denoted.

### <First Embodiment>

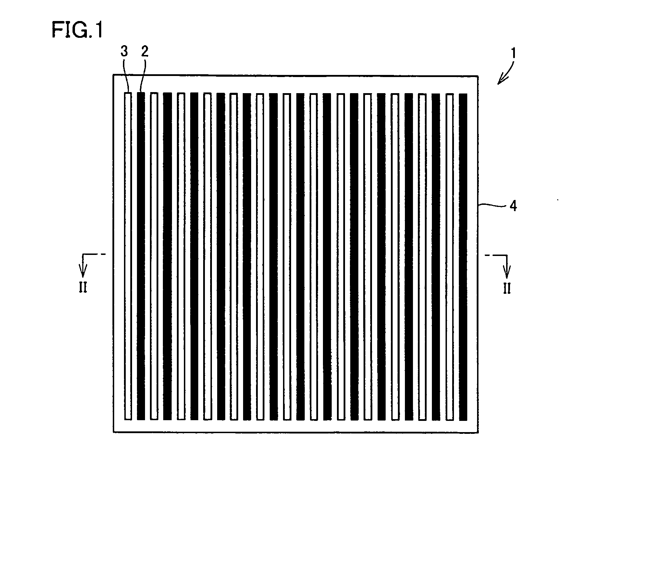

Fig. 1 is a schematic plan view of a back surface of a back electrode type solar cell of a first embodiment. A back electrode type solar cell 1 shown in Fig. 1 has an n type silicon substrate 4 having a light-receiving surface and an opposite, back surface having a strip-shaped electrode for n type 2 and a strip-shaped electrode for p type 3 disposed thereon alternately.

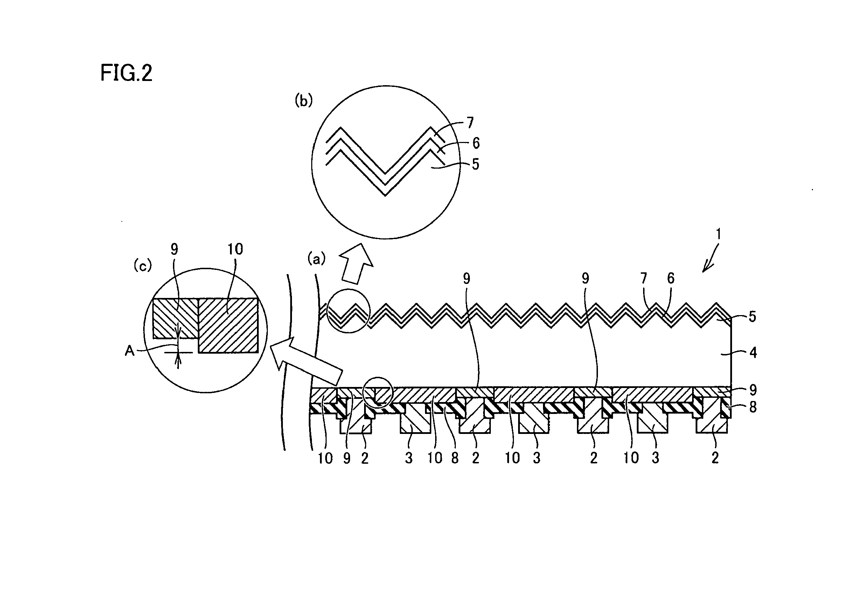

Fig. 2(a) is a schematic cross sectional view along a line II-II of Fig. 1, Fig. 2(b) is a schematic enlarged cross sectional view of a portion of the light-receiving surface of n type silicon substrate 4 shown in Fig. 2(a), and Fig. 2(c) is a schematic enlarged cross sectional view for illustrating a difference in thickness between an n++ layer and a p+ layer shown in Fig. 2(a). As shown in Fig. 2(a) and Fig. 2(b), n type silicon substrate 4 has the light-receiving surface with a concave-convex structure 5 (or a textured structure). Concave-convex structure 5 has concaves and convexes in an order for example of micrometers.

As shown in Fig. 2(a) and Fig. 2(b), a light-receiving surface passivation film 6 is provided on concave-convex structure 5. Light-receiving surface passivation film 6 is formed of silicon nitride film. Furthermore, light-receiving surface passivation film 6 is not more than 10 nm in thickness.

As shown in Fig. 2(a) and Fig. 2(b), an anti-reflection film 7 is provided on light-receiving surface passivation film 6. Anti-reflection film 7 is also formed of silicon nitride film. A thickness of anti-reflection film 7 is 50 nm to 100 nm.

Herein, the silicon nitride film of anti-reflection film 7 has a nitrogen content higher than that of the silicon nitride film of light-receiving surface passivation film 6. Furthermore, the silicon nitride film of light-receiving surface passivation film 6 has a refractive index higher than that of the silicon nitride film of anti-reflection film 7. Note that light-receiving surface passivation film 6 may be silicon oxide film.

Furthermore, an n++ layer 9 which is an n type impurity diffusion layer and a p+ layer 10 which is a p type impurity diffusion layer are provided at the back surface of n type silicon substrate 4 alternately and adjacently. When a bias in a reverse direction (or a reverse bias voltage) is applied to back electrode type solar cell 1 with n++ layer 9 and p+ layer 10 provided alternately and adjacently, a phenomenon occurs in which, as in a typical diode, no substantial current flows for up to breakdown voltage and when voltage larger than breakdown voltage is applied a large current (or a breakdown current) flows and voltage larger than that is not applied to back electrode type solar cell 1. Since this breakdown current flows in the region in which n++ layer 9 and p+ layer 10 are adjacent, back electrode type solar cell 1 having n++ layer 9 and p+ layer 10 alternately and adjacently will have a current passing throughout the back surface of back electrode type solar cell 1. Accordingly, back electrode type solar cell 1 can avoid partially applied voltage, and hence local current leakage and hence heat otherwise generated thereby.

As shown in Fig. 2(c), n++ layer 9 has a surface shallower by a depth A than that of p+ layer 10 and n++ layer 9 on the back surface of n type silicon substrate 4 has a surface concaved as compared with that of a region on the back surface of n type silicon substrate 4 other than n++ layer 9 and n++ layer 9 and p+ layer 10 are disposed to form a concave. Note that depth A is on an order of several tens nanometers for example. Furthermore, the electrode for n type 2 is provided on n++ layer 9, and the electrode for p type 3 is provided on p+ layer 10.

Furthermore, a back surface passivation film 8 formed of silicon oxide film is provided at a portion of the back surface of n type silicon substrate 4. Herein, as shown in Fig. 2(a), back surface passivation film 8 on n++ layer 9 and back surface passivation film 8 on p+ layer 10 have a difference in thickness and back surface passivation film 8 on n++ layer 9 is larger in thickness than back surface passivation film 8 on p+ layer 10.

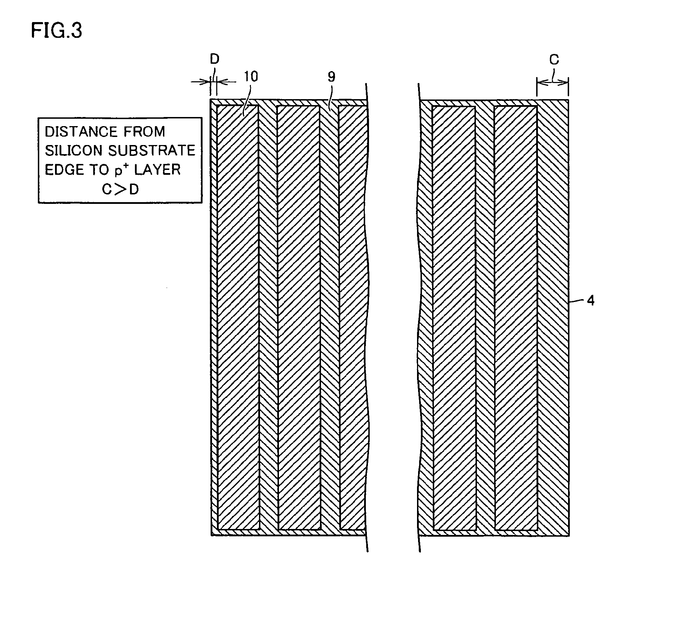

Fig. 3 is a schematic plan view of the back surface of n type silicon substrate 4 when the electrode for n type 2, the electrode for p type 3, and back surface passivation film 8 are removed from back electrode type solar cell 1. Herein, back electrode type solar cell 1 of the first embodiment has n type silicon substrate 4 with a back surface having a peripheral edge provided with n++ layer 9.

N type silicon substrate 4 has a back surface with a peripheral edge provided with n++ layer 9, which is an impurity diffusion layer of the same conductivity type as that of the back surface of n type silicon substrate 4, i.e., n type, so that if n++ layer 9 located at the peripheral edge of the back surface of n type silicon substrate 4 has a surface removed for some reason and n type silicon substrate 4 has a silicon surface exposed or n++ layer 9 extends to a side surface of n type silicon substrate 4 and/or the light-receiving surface of n type silicon substrate 4, n++ layer 9 will contact a surface of the same conductivity type. Such a portion at which a surface of the same conductivity type contacts does not have current leakage, and back electrode type solar cell 1 can thus suppress the current leakage otherwise caused when a bias in a reverse direction (or a reverse bias voltage) is applied thereto.

Note that if n type silicon substrate 4 does not have a back surface with a peripheral edge entirely provided with n++ layer 9, back electrode type solar cell 1 nevertheless does not have its characteristics significantly impaired, and accordingly, n type silicon substrate 4 may have a back surface having a peripheral edge partially provided with an impurity diffusion layer of a conductivity type different from that of n type silicon substrate 4, i.e., p+ layer 10.

Furthermore, as shown in Fig. 3, a distance from an edge of n type silicon substrate 4 to p+ layer 10 (a distance in a direction orthogonal to the longitudinal direction of p+ layer 10), is a distance C at a right side of n type silicon substrate 4 and a distance D at a left side of n type silicon substrate 4 and C > D. Accordingly, a width C of n++ layer 9 at a right peripheral edge of n type silicon substrate 4 and a width D of n++ layer 9 at a left peripheral edge of n type silicon substrate 4 are different form each other. Note that, in the present embodiment, as shown in Fig. 2(a), as well as on n++ layer 9 posed between p+ layers 10, on n++ layer 9 of width C located at the right peripheral edge of n type silicon substrate 4 the electrode for n type 2 is formed.

Furthermore, as shown in Fig. 3, in the back surface of n type silicon substrate 4, regions of n++ layer 9 are all connected to form a single diffusion layer region. Then, p+ layer 10 is each provided in the form of an island, and each of p+ layers 10 in the form of an island is surrounded by n++ layer 9.

Furthermore, preferably, a total area of n++ layer 9 at the back surface of n type silicon substrate 4 is smaller than that of p+ layer 10. This provides a tendency that when back electrode type solar cell 1 generates electric power a short-circuit current of a larger short-circuit current density can be obtained.

Note that, in the above, n++ layer 9 may be divided at at least one location in a direction orthogonal to the longitudinal direction of p+ layer 10. In this case, p+ layer 10 will be provided between the divisions of n++ layer 9.

Furthermore, in the above, p+ layer 10 may be divided at at least one location in the direction orthogonal to the longitudinal direction of p+ layer 10. In this case, n++ layer 9 will be provided between the divisions of p+ layer 10.

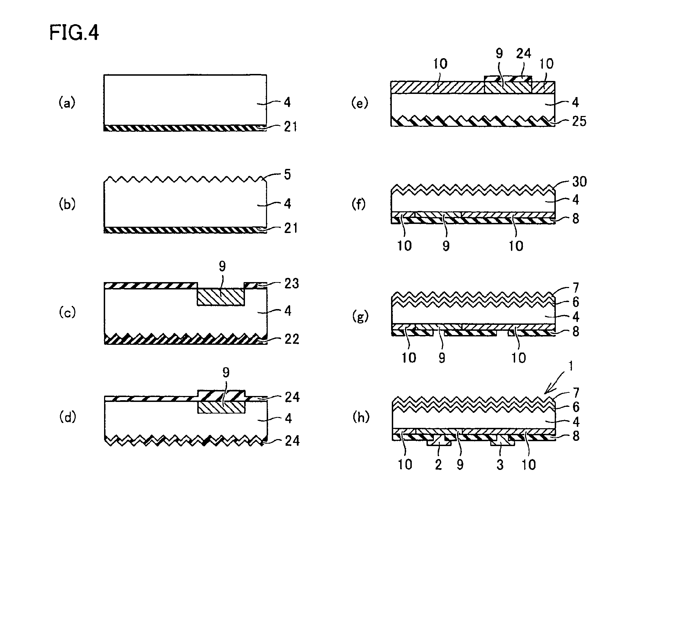

Hereinafter, reference will be made to Figs. 4(a) to 4(h) showing schematic cross sectional views to describe an example of a method for producing the back electrode type solar cell of the first embodiment.

Initially, as shown in Fig. 4(a), on a back surface (the back surface of n type silicon substrate 4), which is an opposite surface to a surface that serves as a light-receiving surface (the light-receiving surface of n type silicon substrate 4), a texture mask 21 is provided. Herein, as texture mask 21 silicon nitride film or the like for example can be implemented. Furthermore, texture mask 21 can be provided for example by CVD (Chemical Vapor Deposition), sputtering or the like.

Then, as shown in Fig. 4(b), concave-convex structure 5 such as a textured structure or the like is formed in the light-receiving surface of n type silicon substrate 4. Concave-convex structure 5 can be formed for example by etching the light-receiving surface of n type silicon substrate 4 with an aqueous solution of sodium hydroxide or an aqueous solution of potassium hydroxide or a similar alkaline aqueous solution that has isopropyl alcohol added thereto and is heated to not less than 70°C and not more than 80°C.

Then, as shown in Fig. 4(c), n++ layer 9 is provided in a portion of the back surface of n type silicon substrate 4. Note that Fig. 4(c) shows n type silicon substrate 4 with the back surface facing upward. Herein, n++ layer 9 can be provided for example as follows:
Initially, texture mask 21 on the back surface of n type silicon substrate 4 is removed.
   Then, a diffusion mask 22, such as silicon oxide film, is provided on the light-receiving surface of n type silicon substrate 4. Then, a masking paste is applied on the back surface of n type silicon substrate 4 at a region other than that to be provided with n++ layer 9, and the masking paste then undergoes a heat treatment to provide a diffusion mask 23.
   Subsequently, vapor-phase diffusion using POCl₃ is employed to diffuse phosphorus to a portion of the back surface of n type silicon substrate 4 that is exposed from diffusion mask 23 to provide n++ layer 9.

Note that the masking paste can contain a solvent, a thickener, and a silicon oxide precursor, for example. Furthermore, the masking paste can be applied for example by ink jet printing, screen printing or the like.

Then, as shown in Fig. 4(d), silicon oxide film 24 is provided on the back surface of n type silicon substrate 4. Herein, silicon oxide film 24 can be provided for example as follows: diffusion masks 22 and 23 and a glass layer provided as phosphorus diffuses in diffusion masks 22 and 23 are removed from n type silicon substrate 4 by a hydrofluoric acid treatment and n type silicon substrate 4 is subsequently thermally oxidized with oxygen or water vapor. Note that n type silicon substrate 4 can be thermally oxidized with oxygen or water vapor by undergoing a heat treatment in an atmosphere of oxygen or water vapor.

In doing so, as shown in Fig. 4(d), silicon oxide film 24 on the back surface of n type silicon substrate 4 at a region where n++ layer 9 is formed (or silicon oxide film 24 on n++ layer 9) can be provided to be larger in thickness than silicon oxide film 24 on the back surface of n type silicon substrate 4 at a region where n++ layer 9 is not formed (or silicon oxide film 24 on a region other than n++ layer 9). Silicon oxide film 24 thus shaped can be formed for example as follows: If thermal oxidation using water vapor is performed at 900°C to provide silicon oxide film 24, silicon oxide film 24 can be provided on n++ layer 9 to have a thickness of 250 nm to 350 nm and silicon oxide film 24 can be provided on a region other than n++ layer 9 to have a thickness of 70 nm to 90 nm. Herein, before the thermal oxidation, n++ layer 9 has a surface having a phosphorus concentration of not less than 5 × 10¹⁹ atoms/cm³, and the thermal oxidation using oxygen is performed in a range of 800°C to 1000°C whereas the thermal oxidation using water vapor is performed in a range of 800°C to 950°C.

Note that in providing p+ layer 10, as will be described later, it is preferable that a diffusion mask of n++ layer 9 has a thickness of not less than 60 nm, and accordingly, difference between the thickness of silicon oxide film 24 on n++ layer 9 and the thickness of silicon oxide film 24 on the region other than n++ layer 9 preferably is not less than 60 nm.

Furthermore, when silicon oxide film 24 is provided by the thermal oxidation, different types and concentrations of impurity diffused into the back surface of n type silicon substrate 4 allow different growth rates of silicon oxide film 24 by the thermal oxidation, and when n type silicon substrate 4 has a back surface with high n type impurity concentration, silicon oxide film 24 can be grown fast. Accordingly, silicon oxide film 24 on n++ layer 9 having an n type impurity concentration higher than n type silicon substrate 4 can be larger in thickness than silicon oxide film 24 on the region other than n++ layer 9 having an n type impurity concentration lower than n++ layer 9.

Note that silicon oxide film 24 is provided by bond of silicon and oxygen in the thermal oxidation.

Then, as shown in Fig. 4(e), p+ layer 10 is provided at a portion of the back surface of n type silicon substrate 4. P+ layer 10 can be provided for example as follows:
Initially, silicon oxide film 24 on the light-receiving surface of n type silicon substrate 4 and silicon oxide film 24 on the back surface of n type silicon substrate 4 at the region other than n++ layer 9 are etched away. Herein, the thickness of silicon oxide film 24 on n++ layer 9 on the back surface of n type silicon substrate 4 is larger than that of silicon oxide film 24 on the region other than n++ layer 9, and hence silicon oxide film 24 can be left only on n++ layer 9 of the back surface of n type silicon substrate 4. Silicon oxide film 24 on n++ layer 9 and silicon oxide film 24 on the region other than n++ layer 9 are etched at different rates, respectively, and silicon oxide film 24 on n++ layer 9 can thus have a thickness of about 120 nm.

For example, when thermal oxidation for 30 minutes using water vapor of 900°C is performed to provide silicon oxide film 24 and silicon oxide film 24 on the region other than n++ layer 9 is removed by hydrofluoric acid treatment, silicon oxide film 24 on n++ layer 9 can have a thickness of about 120 nm. Note that as has been described above, when silicon oxide film 24 on n++ layer 9 has a thickness of not less than 60 nm, silicon oxide film 24 can function suitably as a diffusion mask in providing p+ layer 10.

Thereafter, diffusion mask 25 of silicon oxide film or the like is provided on the light-receiving surface of n type silicon substrate 4 and a solution obtained by dissolving a polymer that is formed by causing a boron compound to react with an organic polymer in an alcoholic aqueous solution is applied to the back surface of n type silicon substrate 4, dried and then undergoes a heat treatment to diffuse boron to the region other than n++ layer 9 to provide p+ layer 10.

Then, as shown in Fig. 4(f), back surface passivation film 8 is provided on the back surface of n type silicon substrate 4. Herein, back surface passivation film 8 can be provided for example as follows:
Initially, silicon oxide film 24 and diffusion mask 25 and a glass layer provided by boron diffusion into silicon oxide film 24 and diffusion mask 25 on n type silicon substrate 4 are removed by hydrofluoric acid treatment.

Then, for example, thermal oxidation using oxygen or water vapor is performed to provide back surface passivation film 8 of silicon oxide film on the back surface of n type silicon substrate 4 and silicon oxide film 30 on the light-receiving surface of n type silicon substrate 4. Herein, a difference in thickness is caused between the thickness of back surface passivation film 8 on n++ layer 9 and that of back surface passivation film 8 on p+ layer 10 and the thickness of back surface passivation film 8 on n++ layer 9 is larger than that of back surface passivation film 8 on p+ layer 10. The difference in thickness of back surface passivation film 8 also appears after back electrode type solar cell 1 is fabricated, as shown for example in Fig. 2(a). Thereafter, silicon oxide film 30 is removed from the light-receiving surface of n type silicon substrate 4.

Then, as shown in Fig. 4(g), light-receiving surface passivation film 6 formed of silicon nitride film is provided on the light-receiving surface of n type silicon substrate 4, and anti-reflection film 7 is provided on light-receiving surface passivation film 6. Light-receiving surface passivation film 6 and anti-reflection film 7 can be provided for example by CVD. Herein, the silicon nitride film of anti-reflection film 7 has a nitrogen content lower than the silicon nitride film of light-receiving surface passivation film 6. Furthermore, the silicon nitride film of light-receiving surface passivation film 6 has a refractive index higher than the silicon nitride film of anti-reflection film 7.

Light-receiving surface passivation film 6 may be silicon oxide film, and if light-receiving surface passivation film 6 is silicon oxide film, silicon oxide film 30 shown in Fig. 4(f) may not be removed and may instead be used as light-receiving surface passivation film 6.

Thereafter, as shown in Fig. 4(g), a portion of back surface passivation film 8 is removed to expose a portion of n++ layer 9 and a portion of p+ layer 10 from back surface passivation film 8. Herein, a portion of back surface passivation film 8 is removed for example as follows: an etching paste is applied to a portion of back surface passivation film 8 by screen printing or the like, and the etching paste is then heated or the like. The etching paste can then be ultrasonically cleaned and then treated with acid and thus removed. The etching paste may for example be an etching paste containing at least one type selected from the group consisting of phosphoric acid, hydrogen fluoride, ammonium fluoride and ammonium hydrogen fluoride as an etching component, and water, an organic solvent and thickener.

Then, as shown in Fig. 4(h), the electrode for n type 2 is provided on n++ layer 9, and the electrode for p type 3 is provided on p+ layer 10. Herein, the electrode for n type 2 and the electrode for p type 3 can be provided for example as follows: silver paste is applied to a predetermined location on back surface passivation film 8 of the back surface of n type silicon substrate 4 by screen printing and the silver paste is then dried and thereafter fired. Back electrode type solar cell 1 of the first embodiment can thus be produced.

Thus in the present embodiment back electrode type solar cell 1 can be produced in a method in which, as shown in Fig. 4(d), utilization of the difference in thickness of silicon oxide film 24 provided by thermal oxidation on the back surface of n type silicon substrate 4 after n++ layer 9 on the back surface of n type silicon substrate 4 is provided can provide a diffusion mask for providing p+ layer 10. Since the step of patterning the diffusion mask for providing p+ layer 10 can be dispensed with, a reduced number of steps can be achieved. Since a large number of equipment can be dispensed with, the productivity of back electrode type solar cell 1 can be increased.

Furthermore, the method for producing back electrode type solar cell 1 according to the present embodiment allows n type silicon substrate 4 to have a back surface with n++ layer 9 and p+ layer 10 provided at positions, respectively, with a minimized misalignment therebetween.

Furthermore, the method for producing back electrode type solar cell 1 according to the present embodiment provides p+ layer 10 by using a diffusion mask provided by utilizing the difference in thickness of silicon oxide film 24 provided by thermal oxidation after n++ layer 9 is provided, and accordingly, n type silicon substrate 4 will have a back surface having an impurity diffusion layer formed of either n++ layer 9 or p+ layer 10.

### <Second Embodiment>

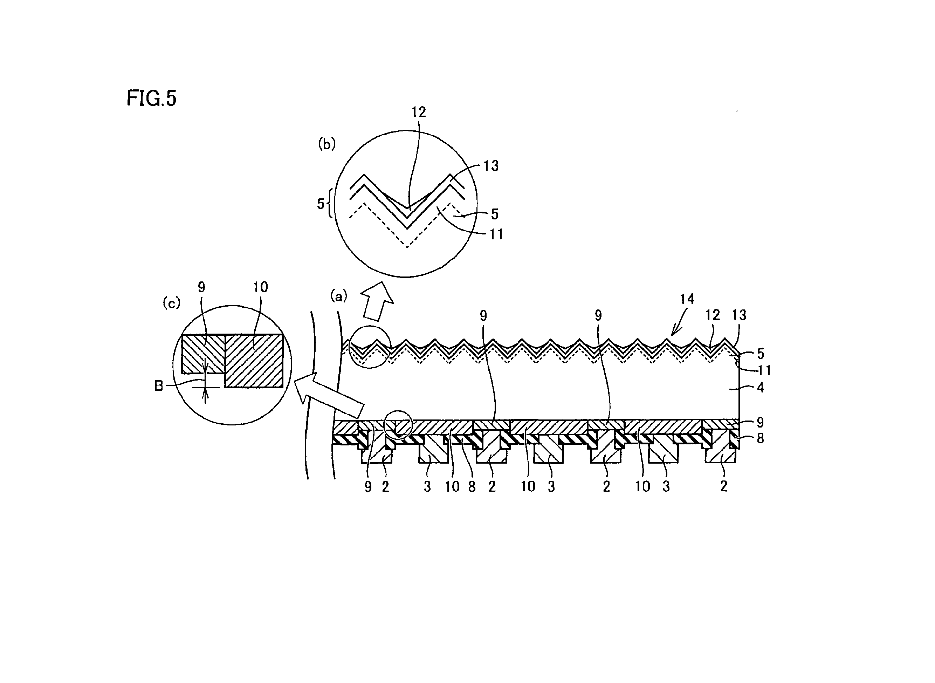

Fig. 5(a) shows a schematic cross sectional view of a back electrode type solar cell in a second embodiment, Fig. 5(b) shows a schematic enlarged cross sectional view of a portion of the light-receiving surface of n type silicon substrate 4 shown in Fig. 5(a), and Fig. 5(c) shows a schematic enlarged cross sectional view for illustrating a difference in thickness between an n++ layer and a p+ layer shown in Fig. 5(a). As shown in Fig. 5(a) and Fig. 5(b), n type silicon substrate 4 has the light-receiving surface with concave-convex structure 5 (a textured structure). Concave-convex structure 5 has concaves and convexes in an order for example of micrometers.

A back electrode type solar cell 14 of the second embodiment is characterized in that an n+ layer 11 which is a light-receiving surface diffusion layer provided by diffusion of n type impurity into the entire light-receiving surface of n type silicon substrate 4 is provided to serve as an FSF (Front Surface Field) layer, and thereon a light-receiving surface passivation film 13 is provided, and on a portion of light-receiving surface passivation film 13 anti-reflection film 12 is provided.

N+ layer 11 provided on the light-receiving surface of n type silicon substrate 4 as the light-receiving surface diffusion layer is a layer of the same n type conductivity type as n type silicon substrate 4, and n+ layer 11 has an n type impurity concentration higher than that of n type silicon substrate 4.

Light-receiving surface passivation film 13 is formed of silicon oxide film. Furthermore, a thickness of light-receiving surface passivation film 13 is 15 nm to 200 nm, preferably 15 nm to 60 nm.

Anti-reflection film 12 contains an n type impurity of the same conductivity type as n type silicon substrate 4, i.e., n type, and is formed for example of film of titanium oxide which contains phosphorus as the n type impurity. While a thickness of anti-reflection film 12 is 30 to 500 nm, it is partially etched away and light-receiving surface passivation film 13 thus has a surface exposed.

Furthermore, anti-reflection film 12 contains phosphorus in the form of phosphoric oxide in an amount of 15% by mass to 35% by mass of anti-reflection film 12. Note that being contained in the form of phosphoric oxide in an amount of 15% by mass to 35% by mass of anti-reflection film 12 means that anti-reflection film 12 has a phosphoric oxide content corresponding to 15% by mass to 35% by mass of the entirety of anti-reflection film 12.

Furthermore, similarly as described in the first embodiment, in the back surface of n type silicon substrate 4 n++ layer (or n type impurity diffusion layer) 9 and p+ layer (or p type impurity diffusion layer) 10 are disposed alternately and adjacently, and n++ layer 9 on the back surface of n type silicon substrate 4 has a surface concaved as compared with that of a region on the back surface of n type silicon substrate 4 other than n++ layer 9, and n++ layer 9 and p+ layer 10 are disposed to form a concave.

As shown in Fig. 5(c), n++ layer 9 has a surface shallower by a depth B than that of p+ layer 10 and the depth B is an order for example of several tens nanometers. Furthermore, the electrode for n type 2 is provided on n++ layer 9, and the electrode for p type 3 is provided on p+ layer 10.

Back electrode type solar cell 14 of the second embodiment can also have n type silicon substrate 4 with a back surface having n++ layer 9 and p+ layer 10 disposed alternately and adjacently, and accordingly, as well as in the first embodiment, back electrode type solar cell 14 can avoid partially applied voltage, and hence local current leakage and hence heat otherwise generated thereby.

Back electrode type solar cell 14 of the second embodiment also has n type silicon substrate 4 with a back surface having n++ layer 9 and p+ layer 10 formed as described in the first embodiment, as shown in Fig. 3, and n type silicon substrate 4 has the back surface with a peripheral edge provided with n++ layer 9. Similarly as described in the first embodiment, this can minimize current leakage otherwise caused when a bias in a reverse direction (or a reverse bias voltage) is applied to back electrode type solar cell 1.

Note that if n type silicon substrate 4 does not have a back surface with a peripheral edge entirely provided with n++ layer 9, back electrode type solar cell 14 nevertheless does not have its characteristics significantly impaired, and accordingly, n type silicon substrate 4 may have a back surface having a peripheral edge partially provided with an impurity diffusion layer of a conductivity type different from that of n type silicon substrate 4, i.e., p+ layer 10.

Furthermore, similarly as described in the first embodiment, as shown in Fig. 3, a distance from the edge of n type silicon substrate 4 to p+ layer 10 (the distance in a direction orthogonal to the longitudinal direction of p+ layer 10) is such that n type silicon substrate 4 at a right peripheral edge has n++ layer 9 having width C and n type silicon substrate 4 at a left peripheral edge has n++ layer 9 having width D, width C being larger than width D, and, as well as n++ layer 9 posed between p+ layers 10, the wide n++ layer 9 on n type silicon substrate 4 at the right peripheral edge is also provided with the electrode for n type 2 thereon.

Furthermore, as shown in Fig. 3, in the back surface of n type silicon substrate 4, regions of n++ layer 9 are all connected to form a single diffusion layer region. P+ layer 10 is each provided in the form of an island, and each of p+ layer 10 in the form of an island is surrounded by n++ layer 9.

Furthermore, preferably, a total area of n++ layer 9 in the back surface of n type silicon substrate 4 is smaller than that of p+ layer 10. This provides a tendency that when back electrode type solar cell 14 generates electric power, a short-circuit current of a larger short-circuit current density can be obtained.

Note that, in the above, n++ layer 9 may be divided at at least one location in a direction orthogonal to the longitudinal direction of p+ layer 10. In this case, p+ layer 10 will be provided between the divisions of n++ layer 9.

Furthermore, in the above, p+ layer 10 may be divided at at least one location in the direction orthogonal to the longitudinal direction of p+ layer 10. In this case, n++ layer 9 will be provided between the divisions of p+ layer 10.

Furthermore, in back electrode type solar cell 14 of the second embodiment, n+ layer 11 which is the light-receiving surface diffusion layer is also of the same conductivity type as n type silicon substrate 4, i.e., n type, and if n++ layer 9 contacts n+ layer 11 which is the light-receiving surface diffusion layer, at a side surface of n type silicon substrate 4, the solar cell's characteristics are not affected thereby.

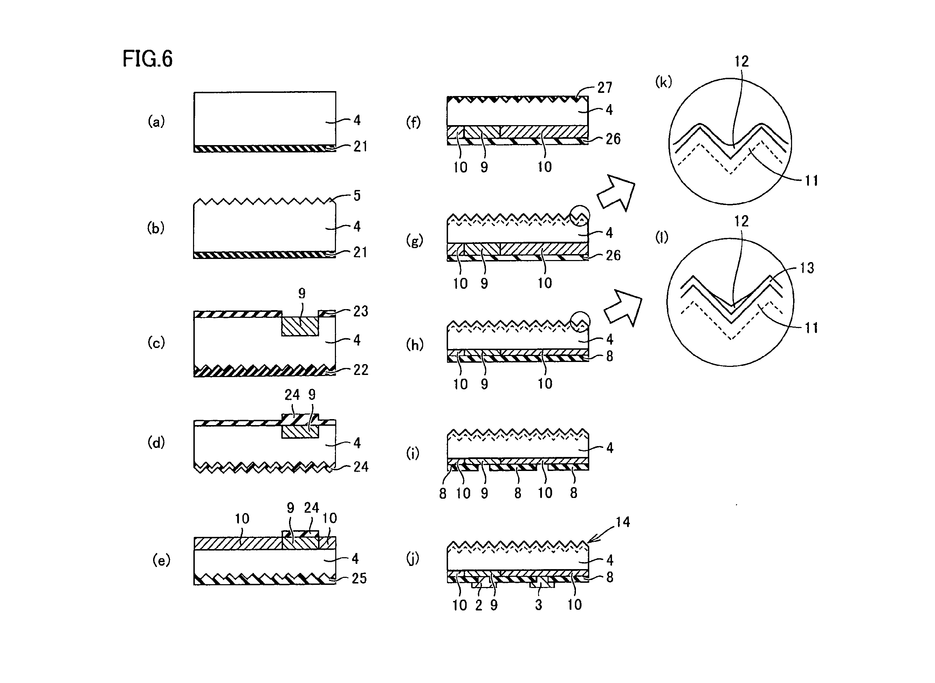

Hereinafter, reference will be made to Figs. 6(a) to 6(l) showing schematic cross sectional views to describe an example of a method for producing back electrode type solar cell 14 of the second embodiment. The steps shown in Fig. 6(a) to Fig. 6(e) are identical to those shown in Fig. 4(a) to Fig. 4(e), and accordingly, the description will be abbreviated, and from the steps shown in Fig. 6(f) will be described.

As shown in Fig. 6(f), a diffusion mask 26 of silicon oxide film or the like is provided on the back surface of n type silicon substrate 4. Herein, diffusion mask 26 can be provided for example as shown in Fig. 6(e), as follows: silicon oxide film 24 and diffusion mask 25, and a glass layer provided by boron diffusion into silicon oxide film 24 and diffusion mask 25 on n type silicon substrate 4 are removed by hydrofluoric acid treatment and thereafter silicon oxide film or the like is provided on the back surface of n type silicon substrate 4 by CVD, sputtering or the like.

Then, as shown in Fig. 6(f), the light-receiving surface of n type silicon substrate 4 is spin-coated with a liquid mixture 27 containing at least a phosphorus compound, titanium alkoxide, and alcohol and is then dried. Herein, liquid mixture 27 is applied in order to provide the light-receiving surface of n type silicon substrate 4 with n+ layer 11 serving as the light-receiving surface diffusion layer and also provide titanium oxide film serving as anti-reflection film 12. Furthermore, the phosphorus compound of liquid mixture 27 can be phosphorus pentaoxide, the titanium alkoxide of liquid mixture 27 can be tetraisopropyl titanate, and the alcohol of liquid mixture 27 can be isopropyl alcohol, for example.

Then, as shown in Fig. 6(g) and Fig. 6(k), n+ layer 11 and anti-reflection film 12 are provided on the light-receiving surface of n type silicon substrate 4. Herein, n+ layer 11 and anti-reflection film 12 can be provided by subjecting the liquid mixture 27 that has been applied to the light-receiving surface of n type silicon substrate 4 and dried to a heat treatment. This heat treatment causes n type impurity, or phosphorus, to diffuse in the light-receiving surface of n type silicon substrate 4 to provide n+ layer 11 throughout the light-receiving surface of n type silicon substrate 4 and also provide titanium oxide film containing phosphorus that serves as anti-reflection film 12. A sheet resistance value of n+ layer 11 after the heat treatment is for example 30-100 Ω/ , desirably 50 ± 10 Ω/ .

Herein, n+ layer 11 and anti-reflection film 12 can be provided by subjecting n type silicon substrate 4 after liquid mixture 27 is subject to a heat treatment for example at not less than 850°C to not more than 1000°C. In other words, this heat treatment causes phosphorus to diffuse from liquid mixture 27 to the light-receiving surface of n type silicon substrate 4 to provide n+ layer 11 and also provide anti-reflection film 12 formed of titanium oxide film containing phosphorus.

Then, as shown in Fig. 6(h) and Fig. 6(l), back surface passivation film 8 is provided on the back surface of n type silicon substrate 4 and light-receiving surface passivation film 13 is also provided on n+ layer 11 of the light-receiving surface of n type silicon substrate 4. Herein, back surface passivation film 8 and light-receiving surface passivation film 13 can be provided for example as follows:
Initially, diffusion mask 26 provided on the back surface of n type silicon substrate 4 is removed by a hydrofluoric acid treatment. In doing so, anti-reflection film 12 is also partially etched with hydrofluoric acid and n type silicon substrate 4 has the light-receiving surface partially exposed. Herein, anti-reflection film 12 is formed of titanium oxide film containing phosphorus and thus resistant to fluoric acid. Accordingly, as shown in Fig. 6(l), only the convexes of concave-convex structure 5 in the light-receiving surface of n type silicon substrate 4 at the portion where anti-reflection film 12 has a small thickness are exposed.

Then, n type silicon substrate 4 is thermally oxidized by oxygen or water vapor. This provides back surface passivation film 8 of silicon oxide film on the back surface of n type silicon substrate 4 and also provides light-receiving surface passivation film 13 of silicon oxide film on the light-receiving surface of n type silicon substrate 4. Note that, as shown in Fig. 6(l), light-receiving surface passivation film 13 is provided on the light-receiving surface of n type silicon substrate 4 at the convexes of concave-convex structure 5 that expose n type silicon substrate 4, and on the light-receiving surface of n type silicon substrate 4 between n+ layer 11 and anti-reflection film 12. It is believed that light-receiving surface passivation film 13 is provided between n+ layer 11 and anti-reflection film 12 because anti-reflection film 12 in the concaves of concave-convex structure 5 of the light-receiving surface is increased in thickness and thus has a portion cracked, and this cracked portion allows oxygen or water vapor to enter and silicon oxide film which is light-receiving surface passivation film 13, to be grown.

Herein, a difference in thickness is caused between the thickness of back surface passivation film 8 on n++ layer 9 and that of back surface passivation film 8 on p+ layer 10 on the back surface of n type silicon substrate 4, and the thickness of back surface passivation film 8 on n++ layer 9 is larger than that of back surface passivation film 8 on p+ layer 10. The difference in thickness of back surface passivation film 8 also appears after back electrode type solar cell 14 is fabricated, as shown for example in Fig. 5(a).

Then, as shown in Fig. 6(i), a portion of back surface passivation film 8 is removed to expose a portion of n++ layer 9 and a portion of p+ layer 10 from back surface passivation film 8. Herein, a portion of back surface passivation film 8 can be removed for example as follows: an etching paste is applied to a portion of back surface passivation film 8 by screen printing or the like, and the etching paste is then heated or the like. The etching paste can then be ultrasonically cleaned and then treated with acid and thus removed. The etching paste may for example be an etching paste containing at least one type selected from the group consisting of phosphoric acid, hydrogen fluoride, ammonium fluoride and ammonium hydrogen fluoride as an etching component, and water, an organic solvent and thickener.

Then, as shown in Fig. 6(j), the electrode for n type 2 is provided on n++ layer 9, and the electrode for p type 3 is provided on p+ layer 10. Herein, the electrode for n type 2 and the electrode for p type 3 can be provided for example as follows: silver paste is applied to a predetermined location on back surface passivation film 8 of the back surface of n type silicon substrate 4 by screen printing and the silver paste is then dried and thereafter fired. Back electrode type solar cell 14 of the second embodiment can thus be produced.

Thus in the present embodiment back electrode type solar cell 14 can also be produced in a method in which, as shown in Fig. 6(d), utilization of the difference in thickness of silicon oxide film 24 provided by thermal oxidation on the back surface of n type silicon substrate 4 after n++ layer 9 on the back surface of n type silicon substrate 4 is provided can provide a diffusion mask for providing p+ layer 10. Since the step of patterning the diffusion mask for providing p+ layer 10 can be dispensed with, a reduced number of steps can be achieved. Since a large number of equipment can be dispensed with, the productivity of back electrode type solar cell 14 can be increased.

Furthermore, the method for producing back electrode type solar cell 14 according to the present embodiment allows n type silicon substrate 4 to have a back surface with n++ layer 9 and p+ layer 10 provided at positions, respectively, with a minimized misalignment therebetween.

Furthermore, the method for producing back electrode type solar cell 14 according to the present embodiment provides p+ layer 10 by using a diffusion mask provided by utilizing the difference in thickness of silicon oxide film 24 provided by thermal oxidation after n++ layer 9 is provided, and accordingly, n type silicon substrate 4 will have a back surface having an impurity diffusion layer formed of either n++ layer 9 or p+ layer 10.

Furthermore, the method for producing back electrode type solar cell 14 according to the present embodiment allows n+ layer 11 and anti-reflection film 12 to be provided in a single step and light-receiving surface passivation film 13 and back surface passivation film 8 to be also provided in a single step. Since a reduced number of steps can be achieved, and a large number of equipment can be dispensed with, the productivity of back electrode type solar cell 14 can be increased.

### <Third Embodiment>

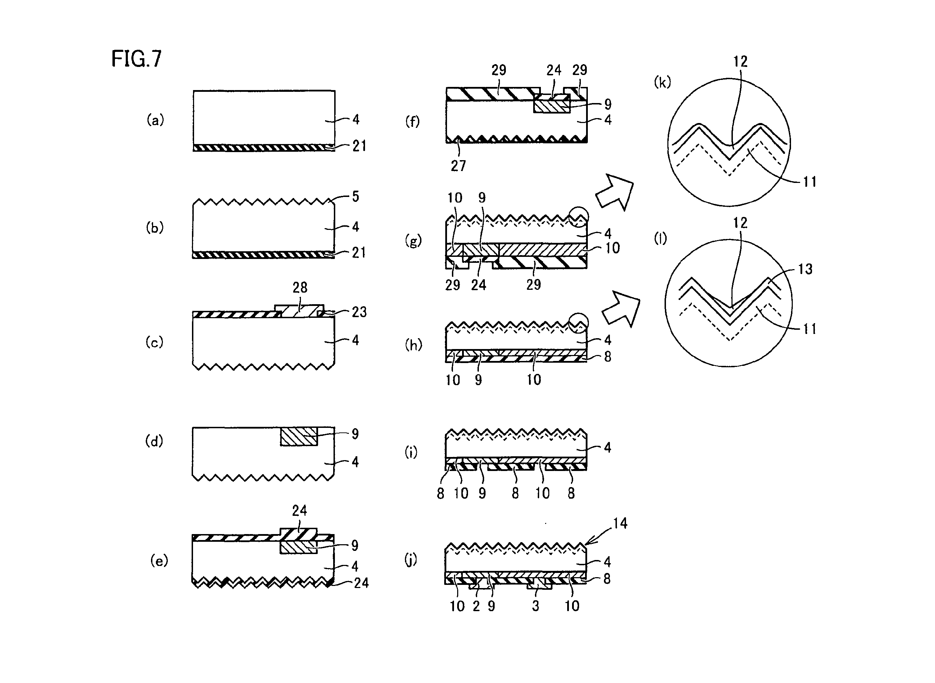

Hereinafter, reference will be made to Figs. 7(a) to 7(l) showing schematic cross sectional views to describe an example of a method for producing a back electrode type solar cell of a third embodiment. The third embodiment is characterized by providing n+ layer 11 which is a light-receiving surface diffusion layer, and p+ layer 10 in a single step. The steps shown in Fig. 7(a) and Fig. 7(b) are identical to those shown in Fig. 6(a) and Fig. 6(b), and accordingly, the description will be abbreviated, and from the steps shown in Fig. 7(c) the description will start.

As shown in Fig. 7(c), after texture mask 21 is removed from the back surface of n type silicon substrate 4, diffusion mask 23 is provided on the back surface of n type silicon substrate 4 at a location other than a location to be provided with n++ layer 9, and phosphorus ink 28 is applied to the location to be provided with n++ layer 9.

Diffusion mask 23 is provided on the back surface of n type silicon substrate 4 at a location other than a location to be provided with n++ layer 9, for example as follows: a masking paste containing a solvent, a thickener and a silicon oxide precursor is applied by ink jet printing, screen printing or the like and the masking paste then undergoes a heat treatment.

Then, phosphorus ink 28 can be applied by ink jetting, photogravure offset printing or the like to cover the back surface of n type silicon substrate 4 at the location to be provided with n++ layer 9 after diffusion mask 23 is provided. Phosphorus ink 28 contains phosphorus and also contains other than phosphorus a solvent, a thickener, a silicon oxide precursor and the like.

Then, as shown in Fig. 7(d), n++ layer 9 is provided on the back surface of n type silicon substrate 4. Herein, n++ layer 9 is provided as follows: phosphorus ink 28 applied on the back surface of n type silicon substrate 4 undergoes a heat treatment to diffuse phosphorus from phosphorus ink 28 to the back surface of n type silicon substrate 4. Thereafter, diffusion mask 23 provided to n type silicon substrate 4 and a glass layer provided as phosphorus diffused in diffusion mask 23, and phosphorus ink 28 having undergone the heat treatment are removed by a hydrofluoric acid treatment.

Then, as shown in Fig. 7(e), silicon oxide film 24 is provided on the light-receiving surface and the back surface of n type silicon substrate 4. Herein, silicon oxide film 24 can be provided for example by thermally oxidizing n type silicon substrate 4 after the formation of n++ layer 9 with oxygen or water vapor.

Herein, as shown in Fig. 7(e), the thickness of silicon oxide film 24 on n++ layer 9 of n type silicon substrate 4 is larger than that of silicon oxide film 24 on the region other than n++ layer 9. Silicon oxide film 24 thus shaped can be formed for example as follows: If thermal oxidation using water vapor is performed at 900°C to provide silicon oxide film 24, silicon oxide film 24 can be provided on n++ layer 9 to have a thickness of 250 nm to 350 nm and silicon oxide film 24 can be provided on the region other than n++ layer 9 to have a thickness of 70 nm to 90 nm. Herein, before the thermal oxidation, n++ layer 9 has a surface having a phosphorus concentration of not less than 5×10¹⁹ atoms/cm³, and the thermal oxidation using oxygen is performed in a range of 800°C to 1000°C whereas the thermal oxidation using water vapor is performed in a range of 800°C to 950°C.

Note that, similarly as described in the first embodiment and the second embodiment, in providing p+ layer 10, as will be described later, it is preferable that a diffusion mask for n++ layer 9 has a thickness of not less than 60 nm, and accordingly, silicon oxide film 24 on n++ layer 9 and silicon oxide film 24 on the region other than n++ layer 9 preferably have a difference in thickness of not less than 60 nm.

Furthermore, as has been set forth above, silicon oxide film 24 on n++ layer 9 having an n type impurity concentration higher than n type silicon substrate 4 can be larger in thickness than silicon oxide film 24 on the region other than n++ layer 9 having an n type impurity concentration lower than n++ layer 9. Accordingly, n++ layer 9 on the back surface of n type silicon substrate 4 has a surface concaved as compared with that of a region on the back surface of n type silicon substrate 4 other than n++ layer 9, i.e., that of p+ layer 10, and n++ layer 9 and p+ layer 10 are disposed to form a concave.

Then, as shown in Fig. 7(f), silicon oxide film 24 on the light-receiving surface of n type silicon substrate 4 and silicon oxide film 24 on the back surface of n type silicon substrate 4 at the region other than n++ layer 9 are etched away. Note that, as has been set forth above, since silicon oxide film 24 on the back surface of n type silicon substrate 4 is provided such that silicon oxide film 24 on n++ layer 9 is larger in thickness than silicon oxide film 24 on the region other than n++ layer 9, a thickness of silicon oxide film 24 left on n++ layer 9 will be for example about 120 nm. As has been described above, when silicon oxide film 24 on n++ layer 9 has a thickness of not less than 60 nm, silicon oxide film 24 can function suitably as a diffusion mask in providing p+ layer 10.

Then, boron ink 29 containing boron is applied for example by ink jetting, photogravure offset printing or the like to cover the location to be provided with p+ layer 10 in the back surface of n type silicon substrate 4. Boron ink 29 can for example be that which contains boron and also contains other than boron a solvent, a thickener, a silicon oxide precursor and the like. Thereafter, boron ink 29 applied to the back surface of n type silicon substrate 4 is sintered.

Then, the light-receiving surface of n type silicon substrate 4 is spin-coated with liquid mixture 27 containing at least a phosphorus compound, titanium alkoxide, and alcohol and is then dried. Herein, liquid mixture 27 is applied in order to provide n+ layer 11 on the light-receiving surface of n type silicon substrate 4 serving as the light-receiving surface diffusion layer and also provide titanium oxide film serving as anti-reflection film 12. Furthermore, the phosphorus compound of liquid mixture 27 can be phosphorus pentaoxide, and the titanium alkoxide of liquid mixture 27 can be tetraisopropyl titanate, and the alcohol of liquid mixture 27 can be isopropyl alcohol, for example.

Then, as shown in Fig. 7(g) and Fig. 7(k), n+ layer 11 which is the light-receiving surface diffusion layer, and anti-reflection film 12 are provided on the light-receiving surface of n type silicon substrate 4 and p+ layer 10 is provided on the back surface of n type silicon substrate 4. Herein, n+ layer 11 and anti-reflection film 12 can be provided by subjecting to a heat treatment the liquid mixture 27 that has been applied to the light-receiving surface of n type silicon substrate 4 and dried. This heat treatment causes n type impurity, or phosphorus, to diffuse in the light-receiving surface of n type silicon substrate 4 to provide n+ layer 11 throughout the light-receiving surface of n type silicon substrate 4 and also provide titanium oxide film containing phosphorus that serves as anti-reflection film 12. After the heat treatment, n+ layer 11 has a sheet resistance value for example of 30-100 Ω/ , desirably 50 ± 10 Ω/ .

Furthermore, at the time, boron ink 29 on the back surface of n type silicon substrate 4 also undergoes the heat treatment, which diffuses a p type impurity, or boron, from boron ink 29 to the back surface of n type silicon substrate 4 and thus provides p+ layer 10 in the back surface of n type silicon substrate 4.

Then, as shown in Fig. 7(h) and Fig. 7(l), back surface passivation film 8 is provided on the back surface of n type silicon substrate 4 and light-receiving surface passivation film 13 is also provided on n+ layer 11 of the light-receiving surface of n type silicon substrate 4. Herein, back surface passivation film 8 and light-receiving surface passivation film 13 can be provided for example as follows:
N type silicon substrate 4 is thermally oxidized by oxygen or water vapor. This provides back surface passivation film 8 of silicon oxide film on the back surface of n type silicon substrate 4 and also provides light-receiving surface passivation film 13 of silicon oxide film on the light-receiving surface of n type silicon substrate 4. Note that, as shown in Fig. 7(l), light-receiving surface passivation film 13 is provided on the light-receiving surface of n type silicon substrate 4 at the convexes of concave-convex structure 5 that expose n type silicon substrate 4, and also on the light-receiving surface of n type silicon substrate 4 between n+ layer 11 and anti-reflection film 12. It is believed that light-receiving surface passivation film 13 is provided between n+ layer 11 and anti-reflection film 12 because anti-reflection film 12 in the concaves of concave-convex structure 5 of the light-receiving surface is increased in thickness and thus has a portion cracked, and this cracked portion allows oxygen or water vapor to enter and silicon oxide film, or light-receiving surface passivation film 13, to be grown.

Herein, a difference in thickness is caused between the thickness of back surface passivation film 8 on n++ layer 9 and that of back surface passivation film 8 on p+ layer 10, and the thickness of back surface passivation film 8 on n++ layer 9 is larger than that of back surface passivation film 8 on p+ layer 10. The difference in thickness of back surface passivation film 8 also appears after back electrode type solar cell 14 is fabricated, as shown for example in Fig. 5(a).

Then, as shown in Fig. 7(i), a portion of back surface passivation film 8 is removed to expose a portion of n++ layer 9 and a portion of p+ layer 10 from back surface passivation film 8. Herein, a portion of back surface passivation film 8 can be removed for example as follows: an etching paste is applied to a portion of back surface passivation film 8 by screen printing or the like, and the etching paste is then heated or the like. The etching paste can then be ultrasonically cleaned and then treated with acid and thus removed. The etching paste may for example be an etching paste containing at least one type selected from the group consisting of phosphoric acid, hydrogen fluoride, ammonium fluoride and ammonium hydrogen fluoride as an etching component, and water, an organic solvent, and thickener.

Then, as shown in Fig. 7(j), the electrode for n type 2 is provided on n++ layer 9, and the electrode for p type 3 is provided on p+ layer 10. Herein, the electrode for n type 2 and the electrode for p type 3 can be provided for example as follows: silver paste is applied to a predetermined location of passivation film 8 on the back surface of n type silicon substrate 4 by screen printing and the silver paste is then dried and thereafter fired. Back electrode type solar cell 14 of the third embodiment can thus be produced.

Thus in a method for producing back electrode type solar cell 14 of the present embodiment, utilization of the difference in thickness of silicon oxide film 24 provided by thermal oxidation on the back surface of n type silicon substrate 4 after n++ layer 9 on the back surface of n type silicon substrate 4 is provided can provide a diffusion mask for providing p+ layer 10. Since the step of patterning the diffusion mask for providing p+ layer 10 can be dispensed with, a reduced number of steps can be achieved. Since a large number of equipment can be dispensed with, the productivity of back electrode type solar cell 14 can be increased.

Furthermore, according to the method for producing back electrode type solar cell 14 of the present embodiment, n type silicon substrate 4 has a back surface with n++ layer 9 and p+ layer 10 provided at positions, respectively, with a minimized misalignment therebetween.

Furthermore, according to the method for producing back electrode type solar cell 14 of the present embodiment, since p+ layer 10 is provided by using a diffusion mask provided by utilizing a difference in thickness of silicon oxide film 24 provided by thermal oxidation after n++ layer 9 is provided, n type silicon substrate 4 will have a back surface having an impurity diffusion layer formed of either n++ layer 9 or p+ layer 10.

In also the method for producing back electrode type solar cell 14 of the present embodiment, similarly as described in the second embodiment, n+ layer 11 and anti-reflection film 12 are able to be provided in a single step and light-receiving surface passivation film 13 and back surface passivation film 8 are able to be also provided in a single step. Since a reduced number of steps can be achieved, and a large number of equipment can be dispensed with, the productivity of back electrode type solar cell 14 can be increased.

Note that while the first to third embodiments have been described for an n type silicon substrate, they may be done with a p type silicon substrate. In this case, if the light-receiving surface diffusion layer exists, it will be a p+ layer using p type impurity and the anti-reflection film will be film containing p type impurity, and the remainder in structure is similar to the structure described above for the n type silicon substrate.

Furthermore, if the p type silicon substrate is used, it is preferable that an n+ layer, which is of a conductivity type different from that of the silicon substrate, i.e., p type, has a total area larger than that of a p++ layer to obtain larger short-circuit current. In this case, adjacent p++ layers may be divided in a direction orthogonal to the longitudinal direction. In this case, the n+ layer is provided between the divisions of the p++ layer. Furthermore, if the n+ layer is divided in the direction orthogonal to the longitudinal direction, the p++ layer is provided between the divisions of the n+ layer.

Furthermore, the concept of the back electrode type solar cell of the present invention encompasses not only a back electrode type solar cell configured with an electrode for p type and an electrode for n type both provided only on one surface (or a back surface) of a semiconductor substrate but also a solar cell of the MWT (Metal Wrap Through) type (i.e., a solar cell having an electrode partially located in a through hole provided in a semiconductor substrate).

### INDUSTRIAL APPLICABILITY

The present back electrode type solar cell and method for producing the same is widely applicable to back electrode type solar cells and methods for producing the same in general.

### REFERENCE SIGNS LIST

1, 14: back electrode type solar cell; 2: electrode for n type; 3: electrode for p type; 4: n type silicon substrate; 5: concave-convex structure; 6, 13: light-receiving surface passivation film; 7, 12: anti-reflection film; 8: back surface passivation film; 9: n++ layer; 10: p+ layer; 11: n+ layer; 21: texture mask; 22, 23, 25, 26: diffusion mask; 24, 30: silicon oxide film; 27: liquid mixture; 28: phosphorus ink; 29: boron ink; 101: back electrode type solar cell; 102: metal contact for n type; 103: metal contact for p type; 104: n type silicon wafer; 105: concave-convex structure; 106: n type front surface diffusion region; 107: antireflection coating; 108: dielectric passivation layer; 109: oxide layer; 110: n+ region; 111: p+ region.

## Claims

1. A back electrode type solar cell (1, 14) comprising:
a silicon substrate (4) of a first conductivity type;
an electrode for said first conductivity type (2) and an electrode for a second conductivity type (3) provided at a back surface opposite to a light-receiving surface of said silicon substrate (4); and
a first conductivity type impurity diffusion layer (9) and a second conductivity type impurity diffusion layer (10) provided at said back surface of said silicon substrate (4),
said first conductivity type impurity diffusion layer (9) and said second conductivity type impurity diffusion layer (10) being adjacently provided,
said first conductivity type impurity diffusion layer (9) being provided at a peripheral edge of said back surface of said silicon substrate (4).

2. The back electrode type solar cell (1, 14) according to claim 1, wherein a total area of said first conductivity type impurity diffusion layer (9) is smaller than that of said second conductivity type impurity diffusion layer (10) in said back surface of said silicon substrate (4).

3. The back electrode type solar cell according to claim 1 or 2, wherein said first conductivity type is n type.

4. The back electrode type solar cell (1, 14) according to any of claims 1 to 3,
wherein a light-receiving surface diffusion layer (11) that contains a first conductivity type impurity at a higher concentration than said silicon substrate (4) is provided in a light-receiving surface of said silicon substrate (4).

5. The back electrode type solar cell according to claim 4, wherein:
a light-receiving surface passivation film (6) is provided on said light-receiving surface diffusion layer (11);
an anti-reflection film (7) is provided on said light-receiving surface passivation film (6); and
said anti-reflection film (7) includes titanium oxide containing an impurity of said first conductivity type.

6. The back electrode type solar cell according to claim 5, wherein said light-receiving surface passivation film (6) has a thickness of 15 nm to 200 nm.

7. The back electrode type solar cell according to claim 5 or 6, wherein said anti-reflection film (7) contains phosphoric oxide as said impurity in an amount of 15% by mass to 35% by mass of said anti-reflection film (7).

8. The back electrode type solar cell (1, 14) according to any of claims 1 to 7,
wherein said second conductivity type impurity diffusion layer (10) is surrounded by said first conductivity type impurity diffusion layer (9).

9. The back electrode type solar cell (1, 14) according to any of claims 1 to 8,
wherein said second conductivity type impurity diffusion layer (10) is provided in a form of an island.

10. The back electrode type solar cell according to claim 8 or 9, wherein said first conductivity type impurity diffusion layer (9) forms a single diffusion layer region.

11. A method for producing a back electrode type solar cell (1, 14), comprising the steps of:
providing a first conductivity type impurity diffusion layer (9) at a portion of a back surface of a silicon substrate (4) of a first conductivity type;
providing silicon oxide film (24) on said back surface of said silicon substrate (4) by thermal oxidation;
providing a second conductivity type impurity diffusion layer (10) at said back surface of said silicon substrate (4) by utilizing a difference in thickness between said silicon oxide film (24) on said back surface of said silicon substrate (4) at a region where said first conductivity type impurity diffusion layer (9) is formed and said silicon oxide film (24) on said back surface of said silicon substrate (4) at a region where said first conductivity type impurity diffusion layer (9) is not formed;
providing an electrode for said first conductivity type (2) on said first conductivity type impurity diffusion layer (9); and
providing an electrode for a second conductivity type (3) on said second conductivity type impurity diffusion layer (10).

12. The method for producing a back electrode type solar cell (1, 14) according to claim 11, further comprising the step of etching a portion of said silicon oxide film (24) before the step of providing said second conductivity type impurity diffusion layer (10).

13. The method for producing a back electrode type solar cell (1, 14) according to claim 12, wherein in the step of etching a portion of said silicon oxide film (24) said silicon oxide film (24) is left only on said first conductivity type impurity diffusion layer (9).

14. The method for producing a back electrode type solar cell (1, 14) according to claim 13, wherein said silicon oxide film (24) left only on said first conductivity type impurity diffusion layer (9) has a thickness of not less than 60 nm.

15. The method for producing a back electrode type solar cell (1, 14) according to any of claims 11 to 14, wherein in the step of providing said first conductivity type impurity diffusion layer (9) a first conductivity type impurity concentration of said first conductivity type impurity diffusion layer (9) is not less than 5 × 10¹⁹ atoms/cm³.
